# DEMANDE DE BREVET EUROPEEN

(11) **EP 0 606 118 A2**
(43) Date de publication de la demande: **13.07.1994**
(21) Numéro de dépôt: 94104315.0
(22) Date de dépôt: 11.05.1990
(51) Int. Cl.: B29C 45/14, B42D 15/10, G06K 19/077

(54) **Procédé de fabrication d'une carte en matière plastique**

(30) Priorité: 26.05.1989 FR 8906908; 02.03.1990 FR 9002624
(62) Demande divisionnaire de: 90401253.1
(71) Demandeur: ESEC (Far East) Limited, HONG-KONG (HK)
(72) Inventeur: Lemaire, Gérard, F-54000 Nancy (FR); Lemaire, Philippe, F-54000 Nancy (FR)
(74) Mandataire: Kägi, Otto Patentanwalt

(57) **Abrégé**

L'invention concerne un procédé de moulage en matière plastique d'une carte décorée au recto et au verso. Afin d'atteindre une fabrication économique de cartes décorées de qualité irréprochable, l'invention propose de décorer la carte (4) en cours du moulage par un ou deux films (50, 51) et/ou une ou deux étiquettes (60, 61) placés dans le moule, et d'injecter la matière plastique entre les deux supports d'image (films et/ou étiquettes) qui sont alors plaqués contre les parois des coquilles du moule à mesure que la matière remplit la cavité du moule.

## Description

La presente invention concerne un procédé de moulage en matière plastique d'une carte décorée au recto et au verso au moyen de supports d'image.

Cette demande étant une demande divisionnaire de la demande de brevet européen initiale no. 90401253.1, le continu entier de ladite demande initiale est stipulé inclus dans la demande divisionnaire. Tandis que la demande initiale se refère au moulage de cartes comportant un module électronique (appelées "cartes à puce"), l'invention selon la présente demande s'occupe de l'aspect de la décoration des deux faces de cartes moulées en matière plastique. L'invention propose donc de résoudre de manière économique le problème de la décoration des cartes.

Selon l'état de la technique actuelle, lesdites cartes en général sont fabriquées complètement avant d'être décorées. On considère habituellement qu'avec les procédés traditionnels d'impression il est courant d'enregistrer des pertes atteignant 10% pour l'impression d'une image. Ces pertes sont dues à un mauvais positionnement de l'image par rapport à la pièce à décorer, et également à une mauvaise réalisation de l'image.

Lorsque l'on imprime les cartes à puce après les avoir fabriquées, on est alors amené à en détruire 10% lors de l'impression d'une face, soit 20% si les deux faces doivent être décorées. Leur destruction entraîne la perte du module électronique qu'elles renferment ce qui financièrement est très important car ledit module étant formé par la bande métallique, le composant électronique avec ses fils de câblage souvent en or, la colle et l'enrobage époxy, son coût est non négligeable. A titre d'exemple, on peut dire que le module d'une carte telle que les cartes utiiisées pour le téléphone qui renferme un composant électronique simple coûte environ 1,5 franc lorsque la carte finie est vendue environ 5 francs. La perte est encore plus importante pour les cartes bancaires qui sont vendues environ 50 francs et contiennent un module renfermant un micro-processeur valant à lui seul 40 francs.

C'est pourquoi suivant l'invention, la carte est décorée au moment de son moulage par la mise en oeuvre d'un film de transfert d'image et/ou d'une étiquette dans le moule. Cette décoration sera selon les besoins, réalisée sur l'une et/ou l'autre face de la carte.

En effectuant selon l'invention, l'impression d'une image ou la mise en place d'une étiquette au moment du moulage de la carte, on s'affranchit des pertes dues aux techniques d'impression puisque l'on utilise des films de transfert d'image et des étiquettes dont la qualité est contrôlée. Toutefois, le moulage de la carte avec ses éléments décoratifs pose des problèmes principalement dus aux dimensions de la cavité de moulage.

A titre d'illustration, nous pouvons dire que la carte terminée a une épaisseur de 840 microns, tandis que les étiquettes utilisées ont une épaisseur généralement comprise entre 65 et 80 microns et qu'un film de transfert muni de son support a entre 70 et 80 microns d'épaisseur.

Le moulage de la carte nécessite donc de remplir convenablement avec la matière plastique une cavité de l'ordre de 700 microns d'épaisseur mais de plus de 40 cm² de surface.

Un autre problème concerne le maintien en place des étiquettes et films que la matière plastique injectée sous une très forte pression a tendance à déplacer.

C'est pourquoi selon l'invention, le procédé de moulage de la carte décorée au recto et au verso est caractérisé en ce que l'un des supports d'image présente une ouverture pour sa mise en place autour d'un bossage traversé par une buse d'injection de l'une des coquilles, tandis que l'autre support d'image est positionné contre la surface du bossage devant la sortie de la buse d'injection et en ce que les deux supports d'image étant maintenus par pinçage dans une zone située autour du bossage l'on injecte la matière plastique entre les deux supports qui sont alors plaqués contre les parois des coquilles à mesure que la matière remplit la cavité du moule.

Dans les procédés usuels la mise en place des étiquettes nécessite de découper au préalable dans l'étiquette du dessus de la carte une fenêtre ayant un contour très exactement identique au contour des contacts qui doivent apparaître à la surface de la carte et ensuite de positionner très précisément l'étiquette de façon que la fenêtre découpée soit exactement mise en place. Cette opération de mise en place très précise est délicate et prend beaucoup de temps.

Par contre, l'emploi combiné d'un film de transfert mis en place avant l'injection et d'une bande métallique pour réaliser les contacts supprime cette opération délicate et onéreuse, car il s'avère que si l'image portée sur le film transfert adhère très bien à la matière plastique injectée, elle n'adhère pas sur le métal; de sorte qu'en retirant le film après injection, l'image se découpe d'elle-même selon le contour des contacts. De plus, l'utilisation d'un tel film de transfert permet également de simplifier son positionnement par rapport à l'empreinte du moule en prévoyant une surface imprimée supérieure à la dimension de la carte. En effet, la partie imprimée se trouvant sur la coquille du moule n'adhère pas à celle-ci.

Lorsque l'on veut fabriquer une carte portant des bandes magnétiques comme cela est souvant nécessaire pour les cartes bancaires, les bandes magnétiques seront mises en place avantageusement au préalable sur une étiquette que l'on place au fond du moule.

Les cartes ainsi obtenues sont de qualité irreprochable et d'un coût très faible.

L'invention sera mieux comprise et d'autres caractéristiques et avantages de celle-ci ressortiront de la description qui va suivre en référence au dessin sur lequel:
La figure 1 est une vue en coupe d'une première forme de réalisation de la partie centrale d'un module électronique;
La figure 2 est une vue partielle à échelle differente;
La figure 2a montre un détail de la figure 2;
La figure 3 est une vue en coupe d'une seconde forme de réalisation de la partie centrale d'un module électronique;
La figure 4 est une vue de dessous d'une forme de réalisation d'un module électronique;
La figure 5 est une vue en coupe selon la ligne V - V de la figure 4;
La figure 6 est une vue en coupe d'une première installation de surmoulage;
La figure 7 est une vue du recto de la carte obtenue par le procédé, objet de l'invention;
La figure 8 est un vue du verso de la carte obtenue par le procédé, objet de l'invention;
La figure 9 est une vue en coupe d'une troisième forme de réalisation de la partie centrale du module électronique;
La figure 10 est une vue en coupe d'une seconde installation de surmoulage;
La figure 11 est une vue du recto de la carte obtenue dans l'installation de la figure 10;
La figure 12 est une vue du verso de la carte obtenue dans l'installation de la figure 10;
La figure 13 représente la première phase d'une troisième forme de mise en oeuvre de l'invention;
La figure 13a est une variante de réalisation du dispositif de la figure 13;
La figure 14 représente la seconde phase de la troisième forme de mise en oeuvre de l'invention;
La figure 15 représente la première phase d'une quatrième forme de mise en oeuvre de l'invention ;
La figure 16 représente la seconde phase de la quatrième forme de mise en oeuvre de l'invention;
La figure 16a est une variante de réalisation du dispositif de la figure 16;
Les figures 17a, 17b, 17c, 17d représentent schématiquement différents modèles de cartes fabriquées par le procédé selon l'invention ;
La figure 18 schématise une chaîne de fabrication de cartes à puce selon l'invention;
Les figures 19a et 19b représentent un détail du moule utilisé;
La figure 20 est une coupe partielle d'un moule utilisé;
Les figures 21a, 21b, 21c sont des vues en coupe suivant la ligne XXI-XXI de la figure 20;
Les figures 22a, 22b représentent des étiquettes pour la décoration de la carte.

La première étape du procédé selon l'invention consiste à réaliser le module électronique que doit porter la carte.

A cet effet, on utilise une des techniques d'assemblage des composants électroniques connues pour la réalisation de boîtiers plastiques du type pour composants de puissance ou pour microprocesseur.

Pour ce faire, on met en oeuvre une bande métallique 19, généralement en cuivre, qui est prédécoupée et préformée afin de former par découpage de tronçons, les contacts 10 nécessaires. Une telle bande est de manière usuelle en cuivre ou alliage cuivre-berylium argenté ou doré.

Sur cette bande métallique 19, on soude la puce électronique 12 par exemple à l'aide de colle conductrice 13 et on câble par soudure thermo-sonique.

Le circuit électronique ainsi préparé sur chaque tronçon de ladite bande 19 est enrobé d'une résine 14 après avoir été positionné dans un moule à cet effet.

Cet enrobage par la résine 14 permet de protéger efficacement la puce 12 et d'éviter toute détérioration du câblage.

La résine 14 utilisée est de préférence une résine, dite de qualité électronique, c'est-à-dire une résine ne comportant pas de constituants tels que le chlore ou le phosphore risquant de détruire la puce. A cet effet, on choisira par exemple une résine époxy ou des silicones.

Cependant pour des composants dont la durée de vie est limitée dans le temps, comme par exemple les cartes de téléphone, on pourra, en protégeant la puce par un vernis, utiliser une résine thermoplastique adaptée ce qui permet de réduire les coûts de fabrication tout en augmentant les cadences car la mise en oeuvre d'une telle résine thermoplastique est beaucoup plus aisée.

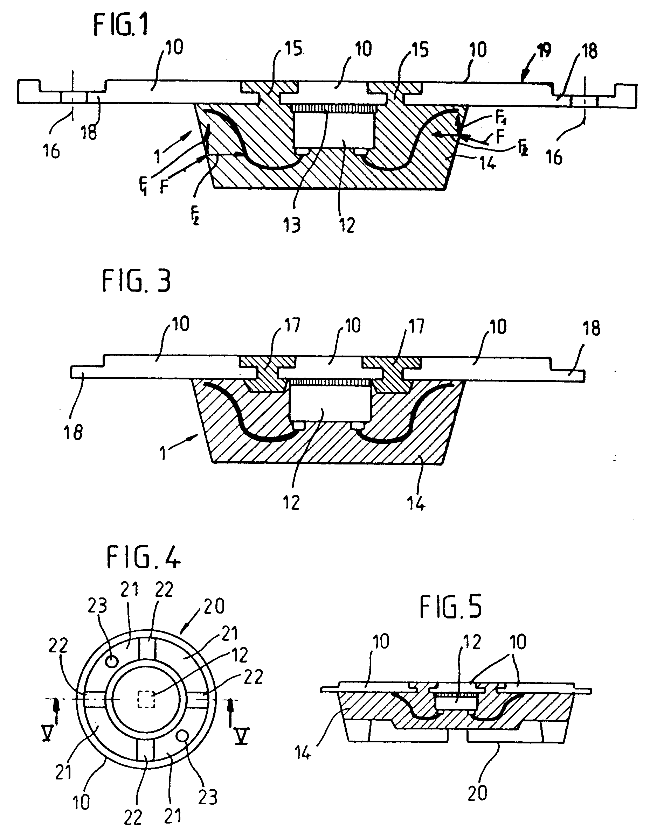

Comme on peut le voir à la figure 1, la résine 14 est admise à remplir les espaces libres 15 entre les contacts 10 afin d'assurer leur liaison mécanique et leur isolement électrique en même temps que la tenue mécanique du module. Les espaces 15 sont prévus avec une surface agrandie sur la face opposée à la puce 12 afin d'assurer un accrochage parfait de la résine 14 avec la bande métallique 19.

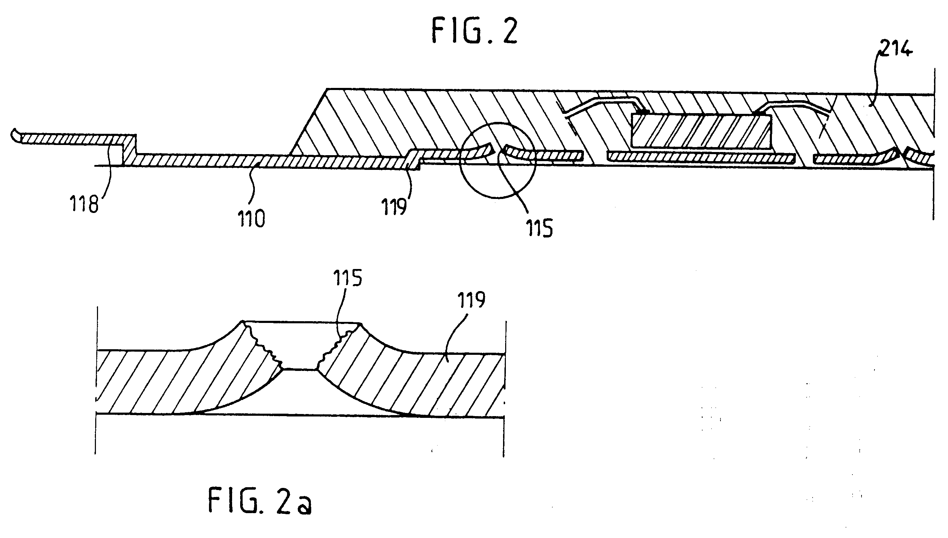

La figure 2 représente une variante de réalisation dans laquelle la bande métallique 119 utilisée est peu épaisse. Dans ce cas, on réalise des crevés 115 de place en place afin d'assurer l'accrochage de la résine 114 et de la bande métallique 119.

Le module électronique 1 nécessaire à la carte que l'on veut fabriquer est alors obtenu en découpant la bande 19 en 16 afin d'en obtenir un tronçon présentant les contacts 10.

Une des difficultés rencontrées dans cette réalisation concerne le fait qu'il est indispensable que la surface des contacts 10 à l'extérieur du module 1 soit parfaitement lisse et propre pour qu'ils assurent convenablement leur rôle dans la carte qui les comportera.

Ces difficultés sont particulièrement importantes lorsque l'espace entre les contacts est important ou lorsque les séparations desdits contacts sont trop éloignées de la zone de serrage du moule utilisé pour l'enrobage ou encore lorsque les liaisons métalliques entre les contacts sont trop fines et ne peuvent être convenablement plaquées par la résine contre le fond du moule.

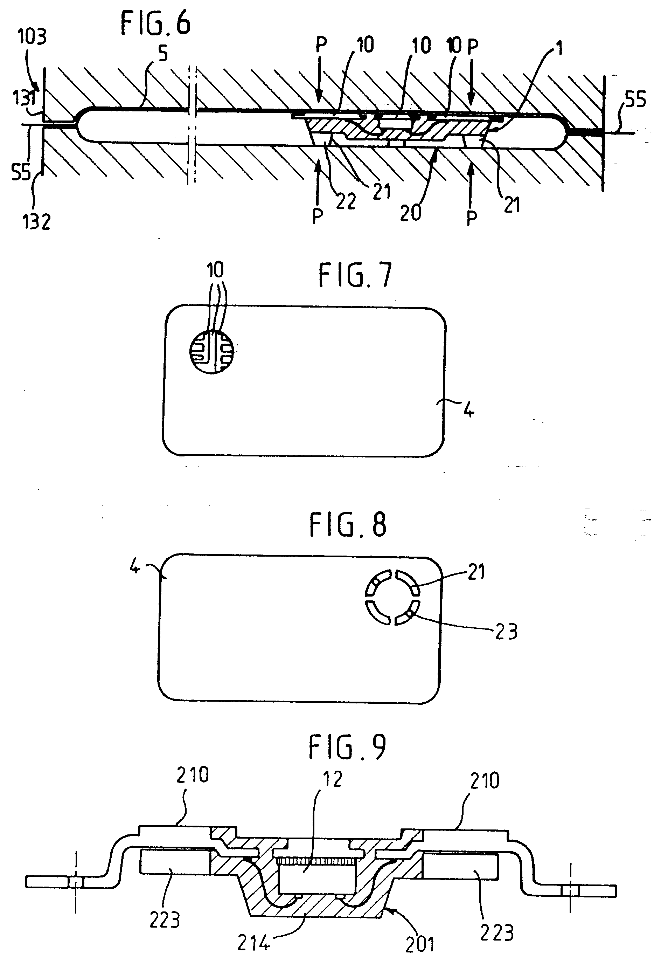

Lorsque cela est possible, on prévoit un nouveau dessin des contacts afin de résoudre ces difficultés et dans le cas inverse, on procède comme visible à la figure 3.

Dans une première étape, on forme des pions 17 de résine sur la bande métallique 19 afin d'assurer la liaison mécanique entre les contacts 10, puis, on effectue le collage et le câblage de la puce 12 après avoir si nécessaire nettoyé la bande 19 dans les zones nécessaires.

Lors de l'enrobage par la résine 14, celle-ci se solidarise auxdits pions 17 pour former le module électronique 1 recherché.

Comme on peut le voir sur les figures 1 à 3, la bande métallique 19, 119 est conformée de manière telle qu'après avoir effectué les découpes de celle-ci en 16 la bordure 18, 118 soit en décrochement par rapport aux contacts 10, 110. Dans le cas de la figure 2, la bande 119 présentera un bord 118 cambré à cet effet.

Cette conformation des bords 18, 118 est utile comme il sera expliqué plus loin, pour assurer une bonne solidarisation du module et de la carte qui le comporte.

Le bloc de résine 14 est prévu avec une forme biseautée en étant plus large près des contacts qu'à l'extrémité qui en est éloignée. Ainsi, comme visible à la figure 1, les forces F exercées par la matière plastique sur ledit bloc 14, lors du remplissage du moule, se décomposent en des forces verticales F1 dirigées vers les contacts 10 et en des forces horizontales F2 dirigées vers l'intérieur du bloc de résine.

Les forces horizontales F2, toutes opposées deux à deux s'annulent tandis que les forces F1 créent une force résultante tendant à plaquer la résine 14 sur les contacts 10 et à déplacer le module vers le haut de la figure 1. L'utilité de cette force résultante sera reprise plus loin.

Les figures 4 et 5 montrent en détail la forme donnée, selon un premier mode de réalisation, au bloc de résine 14 et donc au module 1. Cette forme est spécialement étudiée pour permettre la mise en oeuvre dans de bonnes conditions du procédé suivant l'invention.

Dans cette forme de réalisation, le bloc de résine 14 de forme générale tronconique présente sur sa face opposée à celle portant les contacts 10 une jupe crénelée 20. Dans l'exemple représenté, ladite jupe 20 et découpée en quatre portions 21 par des canaux 22. Ladite jupe 20 présente des ouvertures 23 destinées au positionnement du module 1 dans le moule.

Afin de réaliser le surmoulage du module 1 pour former la carte à puce recherchée, on positionne celui-ci comme visible à la figure 6 dans un moule 103. Le moule 103 de cette première forme de mise en oeuvre, comporte de manière connue en soi deux coquilles 131 et 132 ; l'une des coquilles, ici la coquille inférieure 132, possède des ergots non représentés sur lesquels on engage le module 1.

Le module 1 est engagé sur les tétons par les ouvertures 23 jusqu'à ce que les faces d'extrémités de portions 21 de la jupe 20 reposent sur le fond de la coquille 132 puis l'on positionne la coquille 131 afin de fermer le moule 103.

Cette opération peut être effectuée de manière avantageuse par un outil approprié prenant les modules positionnés sur une table de report lorsque l'on utilise un moule à plusieurs empreintes.

Suivant l'invention, le module 1 est pincé entre les coquilles du moule 103 par l'application d'une pression P sur ledit moule, comme montré schématiquement par les flèches P de la figure 6, dans la zone où se trouve le module.

A cet effet, la jupe 20 est dimensionnée de manière telle que lorsque le module 1 est dans le moule 103, il est en contact avec la coquille 131 par ses contacts 10 et avec la coquille 132 par les extrémités des portions de jupe 20 qui forment des zones d'application privilégiées de l'effort de pression.

Ainsi, lorsque l'on applique la pression, le module 1 est fortement pincé ce qui assure un placage efficace des contacts 10 contre la face interne du moule 103. Ledit placage étant encore amélioré par la résultante des forces F1 dirigées vers les contacts qu'exerce la matière plastique sur le bloc de résine.

De ce fait, la matière plastique lors de son injection ne peut ni déplacer le module 1 et détruire son positionnement, ni s'infiltrer entre le module et la coquille supérieure pour souiller les contacts.

Au cours de l'opération de surmoulage, les canaux 22 de séparation de la jupe 20 assurent le passage de la matière plastique injectée pour le remplissage de la zone intérieure de la jupe 20. Le bord 18, 18' prévu en décrochement par rapport au plan des contacts 10 permet le passage de la matière autour des bords du module 1 afin d'assurer un accrochage parfait dudit module dans la carte plastique.

Les figures 7 et 8 montrent l'aspect recto et verso de la carte 4 ainsi obtenue.

On voit sur la figure 7 que les contacts 10 sont visibles à la surface de ladite carte 4 afin d'être opérationnels lorsque l'on désire utiliser cette carte.

Au verso de ladite carte 4, on voit les faces d'extrémités des portions 21 de jupe ainsi que les ouvertures de centrage 23.

Le module 1 représenté aux figures est un module de section ronde, il est bien entendu que l'on ne sortira pas du cadre de la présente invention en créant un module d'une autre section. On pourra de même adapter à volonté la forme, le nombre et la répartition des ouvertures 23.

La carte 4 peut si désiré être imprimée afin de servir de support publicitaire ou de support d'informations diverses telles que, par exemple, le mode d'emploi de cette carte.

A cet effet, l'invention propose de réaliser cette impression avec un faible coût en utilisant la méthode d'impression dite par transfert d'image.

Comme visible à la figure 6, un film 5 est mis en place dans l'une au moins des coquilles du moule 103. Ce film porte sur sa face tournée vers l'intérieur dudit moule l'image à transférer sur la carte. Le film 5 est prévu avec des portions 55 dépassant du moule et portant des repères optiques permettant d'assurer son positionnement.

Le film de transfert peut-être prévu avec une zone incolore afin de ne pas imprimer les contacts.

On peut également utiliser un film de transfert dont l'image est adaptée à se coller sur la matière plastique mais pas sur les pièces métalliques.

Ainsi, lorsque l'on retire le film à l'issue du moulage, l'image se découpe d'elle-même afin d'épouser le contour des contacts. Cette technique est intéressante dans le cas ou le module est de forme telle que des portions de matière plastique sont disposées entre les contacts car l'on pourra alors décorer aisément ces portions ce qui améliore l'esthétique de la carte.

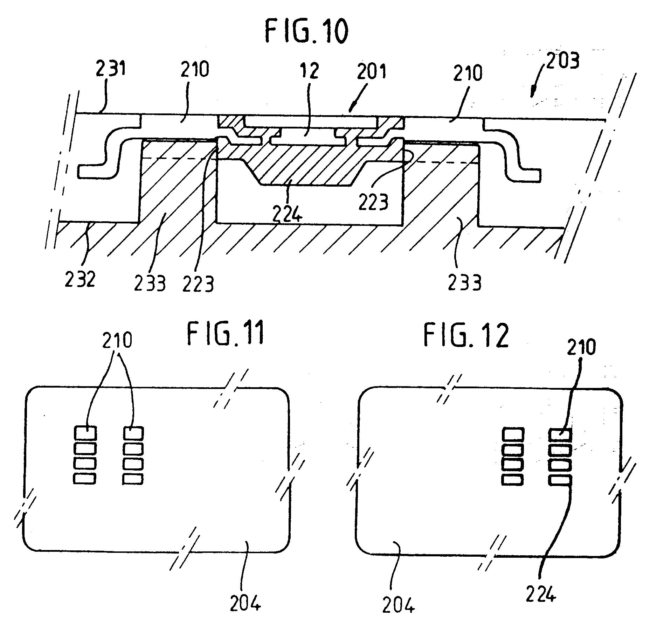

Les figures 9 à 12 montrent une variante de réalisation selon laquelle le module électronique 201 présente des contacts 210 sous la forme de rectangles disposés en colonnes. Comme visible à la figure 11 un tel module peut par exemple comporter deux colonnes de quatre contacts.

Dans cette réalisation, on a prévu le bloc de résine 214 protégeant la puce 12 avec des ouvertures 223 positionnées sous chacun des contacts. Le bloc de résine 214 remplit comme précédemment les espaces libres, non visibles à la figure 9, entre les contacts 210 afin d'assurer la tenue mécanique du module 201.

Le module 201 ainsi fabriqué est mis en place dans un moule 203 en étant positionné par lesdites ouvertures 223 sur des tétons 233 de la coquille 232.

La hauteur des tétons 233 qui assurent le positionnement du module 201 est telle que lorsque ledit module 201 est ainsi placé dans le moule 203 la hauteur totale soit égale à la hauteur de la cavité du moule ; ainsi, lorsque l'on referme ledit moule, les contacts 210 sont en appui contre la face interne de la coquille 231.

On peut alors en exerçant, comme représenté à la figure 6, une pression P sur les coquilles 231, 232, pincer le module 201 dans le moule et obtenir une carte 204 dont le recto présente lesdits contacts 210 (figure 11).

Le verso de la carte 204 présente quant à lui des ouvertures borgnes 224 au fond desquelles on peut distinguer le dessous des contacts 210.

Les essais de mise en oeuvre du procédé tel qu'il vient d'être décrit, ont permis d'obtenir des cartes tout à fait satisfaisantes mais présentant des cavités dans leur verso.

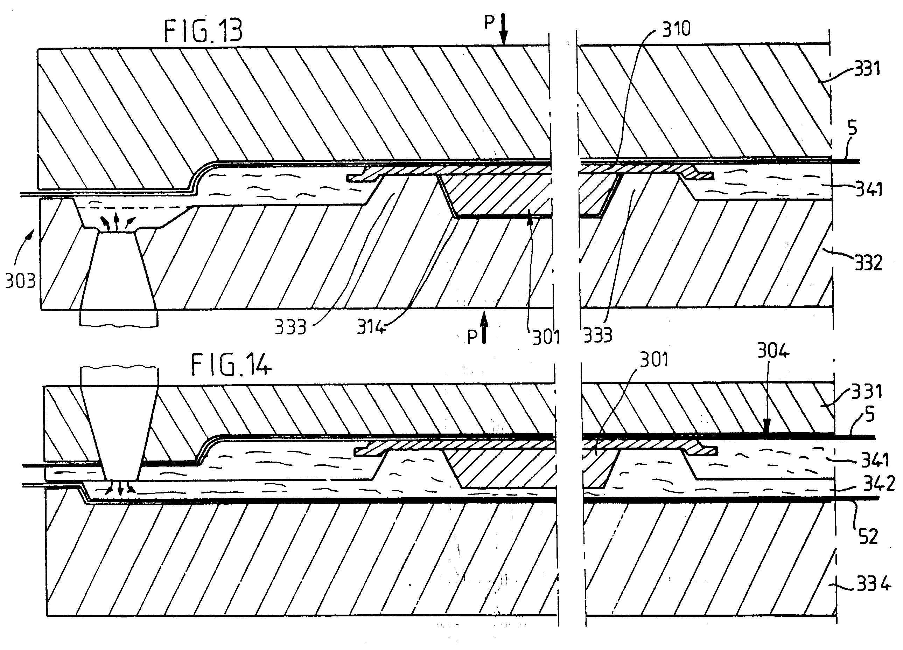

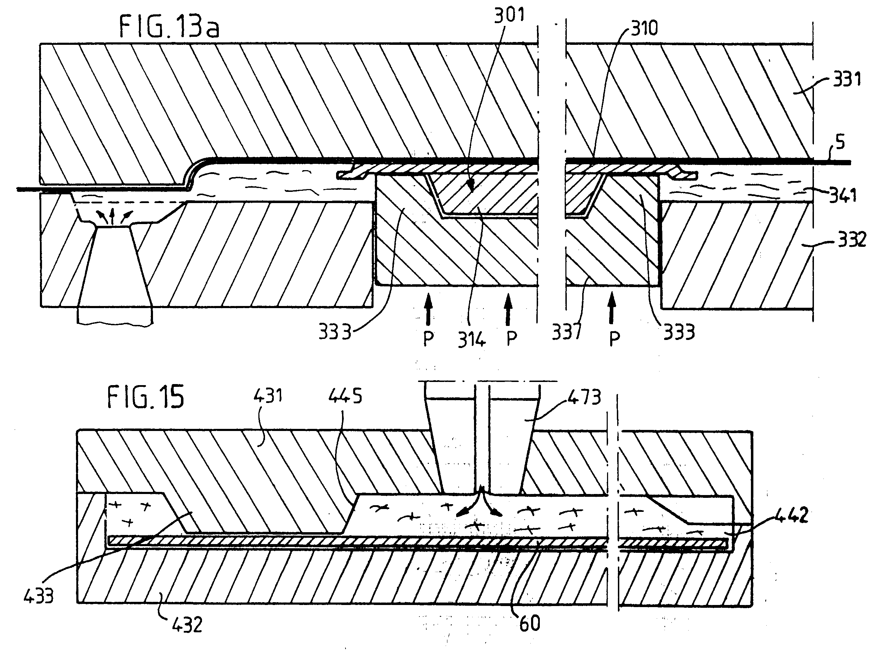

On va maintenant décrire en référence aux figures 13 à 16 deux formes de mise en oeuvre de l'invention par lesquelles on obtient une carte à puce de dimension parfaite comme précédemment, ayant de plus l'avantage de ne pas présenter de cavités dans son verso.

Suivant ces nouvelles formes de mise en oeuvre, la carte est réalisée en deux injections successives.

Les figures 13, 13a et 14 illustrent une troisième forme de mise en oeuvre de l'invention.

La figure 13 représente le moule 303 formé d'une coquille supérieure 331 et d'une coquille inférieure 332 utilisé pour la première phase de la fabrication.

Le module électronique 301 est positionné dans la coquille inférieure 332, par des tétons 333, avec ses contacts 310 dirigés vers la coquille supérieure 331.

Ces tétons 333 peuvent être de toutes formes et dispositions utiles pour assurer un arrêt en rotation dudit module 301 en coopérant avec la résine 314.

On pourra par exemple et comme décrit précédemment prévoir la mise en place desdits tétons 333 dans des ouvertures ménagées dans la résine 314. Suivant une autre forme de réalisation, on forme un bloc de résine 314 de section non circulaire, par exemple polygonale et les tétons 333 sont alors des plots positionnés contre chacune des faces ou une couronne de section interne adaptée à la forme dudit bloc de résine.

L'espace libre à l'intérieur du premier moule est d'une hauteur toujours inférieure à l'épaisseur de la carte 304 que l'on désire fabriquer.

Afin d'assurer l'impression de la carte à puce en même temps que le moulage, on positionne contre la paroi interne de la coquille supérieure un film 5 de transfert d'image. La hauteur des tétons 333 est telle que lorsque le module 301 est positionné dessus, la hauteur totale de ce montage soit égale à l'espace libre dans le moule.

Lorsque le film 5 et le module 301 sont en place, le moule 303 est fermé et l'on applique, comme représenté par les flèches P, une pression sur les coquilles afin que le module soit pincé dans le moule pendant la durée de l'injection. Cette pression P est réglable et différente de la pression de fermeture du moule. Ce pincement permet que la matière plastique, qui est injectée sous une pression de l'ordre de 700kg/cm², ne s'infiltre pas entre les contacts 310 et la coquille supérieure 331 du moule ce qui souillerait les contacts et obligerait à prévoir une phase de nettoyage au cours de la fabrication.

Par ce pincement, on est également assuré que le module n'est pas entraîné par la matière et qu'il garde une position parfaite.

En variante, tel que représenté a la figure 13a, on met en oeuvre un insert 337 prévu dans la coquille 332. Cet insert 337 forme une portion de la paroi interne du moule qui présente les tétons 333. La pression P est appliquée uniquement sur cet insert 337, ce qui améliore encore le pincement du module électronique 301.

La partie du moule située a droite sur la figure n'est pas représentée car de manière connue en soi dans le moulage, le moule peut être à une seule ou à plusieurs empreintes afin de former une grappe de cartes.

Au cours de cette phase de moulage, une première partie 341 de la carte à puce est réalisée.

Après durcissement de la matière plastique, la coquille inférieure 332 est démontée afin de former un second moule par la mise en oeuvre d'une seconde coquille inférieure 334. De manière avantageuse, le cycle dure environ 12 secondes.

Cette seconde coquille inférieure 334 est de forme telle que l'empreinte du second moule qu'elle forme avec la coquille supérieure 331 soit celle de la carte 304 à puce recherchée. Un second film 52 pour transfert d'image est placé contre la paroi interne de cette seconde coquille inférieure s'il est nécessaire de marquer la face de la carte 304 ne portant pas les contacts.

On surmoule alors une seconde partie 342 de la carte à puce sur la première partie 341. Ladite seconde partie 342 est telle qu'elle remplisse les cavités laissées par les tétons 333.

A ce stade, il n'est plus nécessaire d'appliquer une pression sur les coquilles car le module est déjà positionné et maintenu en position par la première partie 341.

La carte à puce 304 obtenue après ces deux phases de moulage est parfaitement plane sur ses deux faces et comporte de plus un module électronique 301 positionné de manière exacte.

Cette forme de réalisation présente l'avantage de permettre d'obtenir des cartes 304 d'épaisseur régulière quelle que soit la dispersion éventuelle des cotes du module. Ceci est dû au fait que la cavité du second moule formé des coquilles 331 et 334 a une dimension fixe et que lors de l'injection, la matière formant la seconde partie 342 de la carte remplit les vides de la cavité en s'adaptant aux dimensions du module 301.

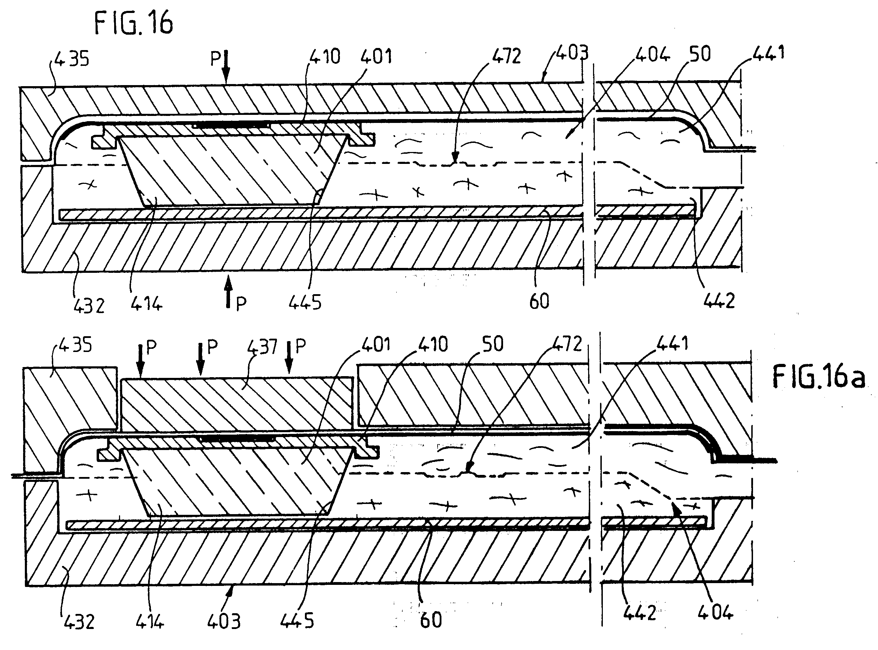

Les figures 15, 16, 16a représentent une quatrième mise en oeuvre de l'invention.

Dans cet exemple de mise en oeuvre, on moule dans une première phase la partie 442 de la carte 404 qui ne renferme pas le module électronique 401.

Comme on peut le voir à la figure 15, la coquille supérieure 431 du moule comporte un insert 433 destiné à former des moyens de positionnement du module tels qu'une cavité 445 dans la partie 442 de carte 404.

Cet insert 433 et donc la cavité 445 ont une section égale à la section du bloc de résine 414 du module 401 devant être mis en place. Ce bloc de résine 414 sera à cet effet prévu de préférence de section non circulaire.

On pourrait bien entendu former un bloc de résine 414 de section circulaire mais il faut alors prévoir dans l'insert 433 des cavités permettant de former des ergots dans ladite cavité 445 ce qui complique la réalisation du moule.

Contre la paroi interne de la coquille inférieure 432, on positionne les éléments destinés au marquage de la carte.

Ces éléments peuvent être comme précédemment décrits un film pour transfert d'image mais peuvent comme représenté être formés par une étiquette 60.

Lors de la réalisation d'une carte bancaire nécessitant la présence de bandes magnétiques, lesdites bandes magnétiques seront mise en place sur cette étiquette par avance par tout procédé connu tel que laminage, sérigraphie ou impression. L'étiquette est recouverte d'un vernis prévu pour être glacé à chaud dans le moule.

Bien entendu, le pavé de signature et l'hologramme usuellement présents sur une carte bancaire seront soit mis en place sur la carte après sa fabrication, soit prévus sur l'étiquette ou le film de transfert utilisé au cours du moulage.

Lorsque le moule est ainsi préparé, on procède à la première phase de moulage schématisée a la figure 15 pour former la partie 442 de la carte 404.

Après durcissement de la matière plastique, le moule est ouvert et la coquille supérieure 431 est ôtée.

On procède alors à la mise en place du module électronique 401 avec son bloc de résine 414 dans la cavité 445 de la partie 442 déjà moulée de la carte.

Les contacts 410 sont, tels que représenté à la figure 16, tournés vers le haut. Les moyens de positionnement du module 401 formés par la cavité 445 de la partie 442 sont de hauteur telle que lesdits contacts 410 soient plaqués contre la paroi du moule 403 lorsqu'il est fermé par une seconde coquille supérieure 435 à l'intérieur de laquelle on a positionné si nécessaire un film 50 de transfert d'image.

Comme précédemment expliqué, on exerce une pression P sur les coquilles du moule ou comme représenté à la figure 16a sur un insert 437 afin de pincer convenablement le module électronique 401. La seconde phase de moulage est alors effectuée afin de surmouler une deuxième partie 441 de la carte 404 sur la partie 442.

On remarque que l'empreinte 472 laissée par la buse d'injection 473 est alors noyée dans la carte, ce qui permet de prévoir tout emplacement désiré pour cette buse.

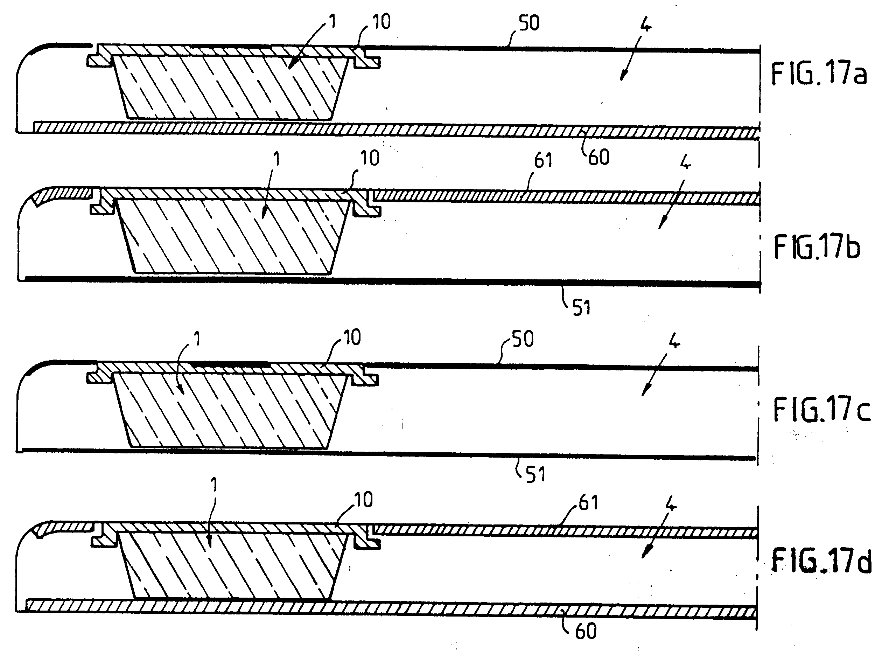

Bien entendu et comme représenté schématiquement sur les figures 17a à 17d, on peut selon les besoins prévoir soit des étiquettes 60, 61, soit des films 50, 51 de transfert d'image sur chaque face de la carte 4. On a également schématisé sur les figures 17a et 17c le fait que lorsque le film 50 est prévu sur la face présentant les contacts 10 du module électronique 1, on peut prévoir d'imprimer la portion centrale inutilisée de ceux-ci ce qui permet de cacher à la vue les liaisons entre contacts, tandis que les étiquettes sont obligatoirement découpées pour laisser ces contacts libres. Ces quatre modèles peuvent indifféremment être obtenus par l'une ou l'autre des mises en oeuvre décrites précédemment, il suffira à cet effet de positionner soit un film transfert soit une étiquette dans les moules.

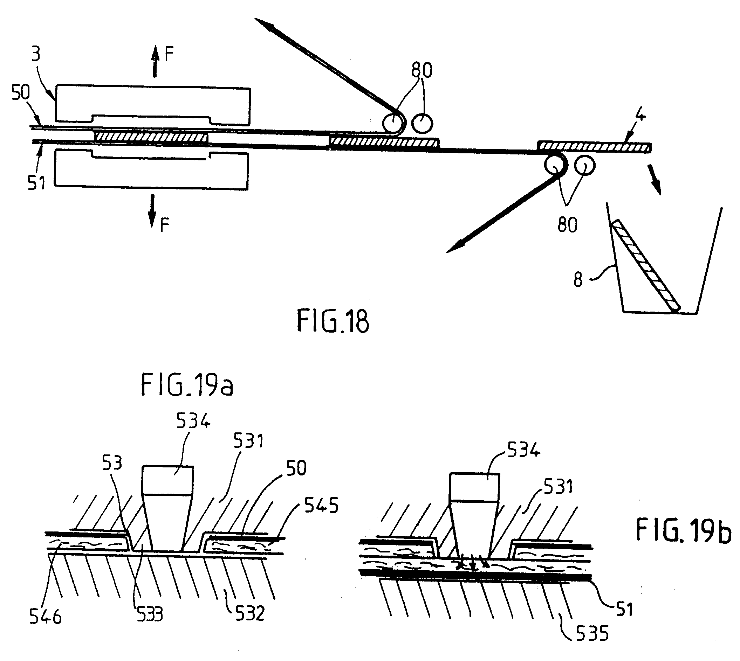

La figure 18 schématise une installation pour la fabrication de cartes selon le procédé de l'invention.

On y voit un moule 3 avec ses coquilles supérieures et inférieures déplaçables dans le sens des flèches F pour l'ouverture.

On procède alors au moulage de la carte comme il vient d'être décrit en changeant l'une des coquilles lorsque l'on utilise la troisième ou quatrième forme de mise en oeuvre puis à l'aide du ou des films 50, 51 s'ils sont utilisés pour le transfert d'image, on peut après retrait des coquilles entraîner la carte ou la grappe de cartes moulée a l'extérieur du moule 3.

Les films sont ensuite enlevés l'un après l'autre par passage sur des rouleaux de renvoi 80 et les cartes 4 sont récupérées dans un récipient de stockage ou de transfert 8. Lorsque les cartes 4 sont décorées avec des étiquettes 60, 61 la même installation peut être utilisée, les cartes seront soit directement prises dans le moule, soit extraites par la mise en oeuvre d'un film solidarisant lesdites étiquettes.

Les figures 19a, 19b représentent un détail des moules dont la mise en oeuvre facilite le positionnement des films transferts lors du moulage d'une carte en deux phases successives.

La figure 19a montre un moule formé des coquilles 531, 532 pour le moulage de la première partie d'une carte, ici la partie supérieure. Dans le moule représenté, deux cartes 545 et 546 sont moulées en même temps. La coquille supérieure 531 du moule présente alors un bossage 533 positionné entre les différentes empreintes de cartes dans lequel débouche une buse d'injection 534.

Ce bossage 533 est alors utilisé pour la mise en place du film de transfert 50 par une ouverture 53 de celui-ci. Le film peut également, comme représenté a la figure 14, être positionné par la buse d'injection.

Au cours de la première phase du moulage, la buse d'injection 534 n'est pas utilisée et la matière est injectée par des buses non représentées de la coquille 532 afin de plaquer le film de transfert 50 contre la paroi de la coquille 531 par la matière plastique..

La buse 534 est par contre mise en oeuvre, comme représenté à la figure 19b, lors de la seconde phase de moulage après avoir remplacé la coquille 532 par la nouvelle coquille 535. De la même manière, la matière plastique en remplissant le moule plaque le film 51 contre la paroi de la coquille 535.

Une telle disposition pourra être utilisée indifféremment dans chacune des coquilles.

Bien entendu, les films de transfert 50 et 51 pourront être remplacés par des étiquettes reliées les unes aux autres par un film support ou encore présentant une languette que l'on positionne dans la zone du bossage 533. Les explications restent valables pour tout support d'image de type connu.

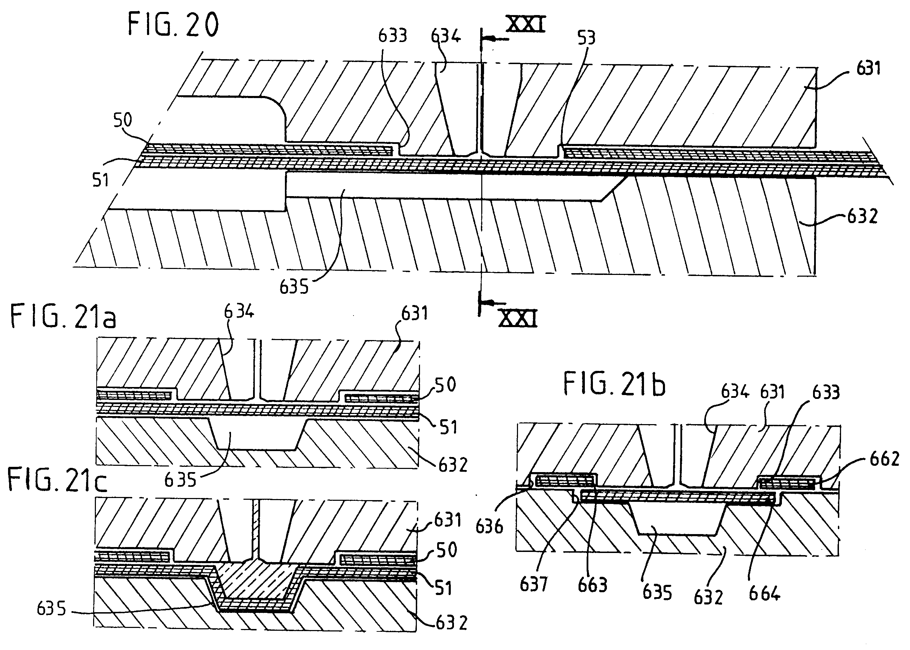

Les figures 20 et 21 permettent d'illustrer le moulage d'une carte réalisée en une seule phase d'injection avec un élément de décoration sur chacune de ses faces.

La figure 20 montre le moule formé des coquilles 631 et 632 dans la cavité duquel devra être réalisée une carte.

L'une des coquilles, ici la coquille 631 supérieure est munie d'une buse d'injection 634 débouchant dans un bossage 633 situé à l'extérieur de la cavité de moulage. La buse 634 débouche en face d'un canal 635 prévu dans la coquille 632 pour diriger la matière plastique injectée vers la cavité.

Le film de transfert 50 devant être plaqué contre la paroi de la coquille 631 présente, comme décrit en liaison avec la figure 19a, une ouverture 53 par laquelle il est positionné autour du bossage 633, tandis que le film de transfert 51 est positionné contre la surface du bossage devant la sortie de la buse d'injection 634. Les films de transferts 50, 51 sont comme visible à la figure 20 et sur les figures 21a et 21c maintenus en place par leur pincement dans le plan de joint des coquilles 631, 632 dans les zones entourant le bossage comportant la buse 634 et le canal 635.

La figure 21c illustre l'injection de la matière plastique, comme on peut le voir, c'est la matière qui plaque le film 51 au fond du canal 635. De même, la matière en s'écoulant vers la cavité de moulage écarte les films 50 et 51 qu'elle plaque correctement contre les parois du moule à mesure qu'elle remplit la cavité.

Par une telle mise en oeuvre, on obtient une carte selon l'invention présentant de bonnes qualités tant du point de vue de son utilisation que du point de vue esthétique.

La figure 21b représente une vue analogue à celle de la figure 21a dans le cas ou les éléments décoratifs sont des étiquettes munies de languettes 662, 664 pour leur maintien en place dans le moule.

Les coquilles 631, 632 présentent alors des logements 636, 637 pour la mise en place de ces languettes. Les languettes 662, 664 sont alors maintenues par pincement contre la face de la coquille opposée selon une méthode semblable à celle utilisée pour les films 50, 51. La matière plastique est injectée entre les languettes, ce qui plaque la languette 664 contre la paroi du canal 635 et les étiquettes contre les parois de la cavité de moulage.

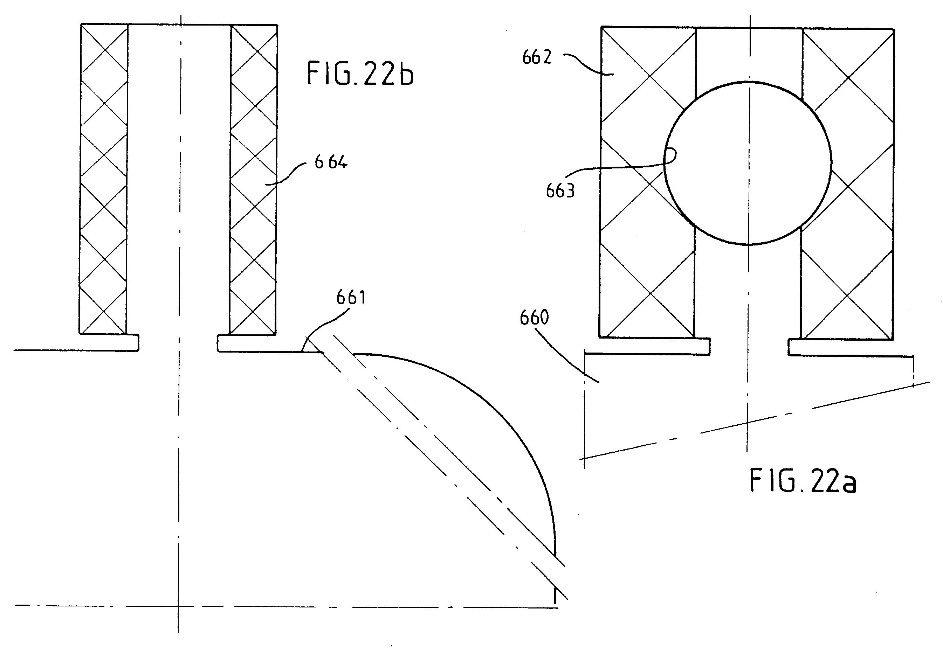

On a représenté aux figures 22a et 22b les étiquettes utilisées. La figure 22a montre l'étiquette supérieure 660 utilisée ; celle-ci présente une languette 662 globalement rectangulaire et l'on voit l'ouverture 663 destinée au positionnement de celle-ci autour du bossage 633 de la coquille 631. La figure 22b montre l'étiquette inférieure 661 avec sa languette 664.

Les zones hachurées symbolisent les zones d'application de l'effort de pincement destiné à leur maintien en place dans le moule au cours du moulage.

De manière connue en soi dans la technique de moulage et tel que schématisé sur les figures, il est prévu entre les deux parties de la carte une surface de séparation non plane afin d'obtenir un bon accrochage desdites parties et d'optimiser le rapport de remplissage surface/épaisseur du moule pour chacune des deux injections en fonction de la position des buses d'injection.

## Revendications

1. Procédé de moulage en matière plastique d'une carte décorée au recto et au verso au moyen de supports d'image, **caractérisé** en ce que la carte (4) est décorée au cours du moulage par un ou deux films (50, 51) et/ou une ou deux étiquettes (60, 61) placés dans le moule, et en ce que l'on injecte la matière plastique entre les deux supports d'image qui sont alors plaqués contre les parois des coquilles du moule à mesure que la matière remplit la cavité du moule.

2. Procédé selon la revendication 1, caractérisé en ce qu'on utilise pour la décoration de la carte (4) un film de transfert d'image au moins sur l'une des faces sur laquelle apparait un corps métallique (19), l'image portée par le film de transfert d'image adhérant sur la matière plastique injectée mais ne pouvant pas adhérer sur le métal dudit corps métallique (19) de telle sorte qu'en retirant le film après injection, l'image se découpe d'elle-même selon le contour du métal.

3. Procédé selon la revendication 1, caractérisé en ce que lesdites étiquettes (60, 61) portent des bandes magnétiques.

4. Procédé selon l'une des revendications précédentes, caractérisé en ce que le moulage de la carte est réalisé en deux phases successives, une seconde partie (342, 442) de la carte étant surmoulée sur la première partie (341, 441).

5. Procédé selon l'une des revendications précédentes, caractérisé en ce que l'un des supports d'image (50, 660) présente une ouverture (53, 663) pour sa mise en place autour d'un bossage (633) traversé par une buse d'injection (634) de l'une des coquilles (631) du moule, tandis que l'autre support d'image (51, 661) est positionné contre la surface du bossage (633) devant la sortie de la buse d'injection (634).

6. Procédé selon la revendication 5, caractérisé en ce qu'au moins un des supports d'image est maintenu par pinçage dans une zone située autour dudit bossage (633).
